# EUROPEAN PATENT SPECIFICATION

(11) **EP 0 381 735 B1**
(45) Date of publication and mention of the grant of the patent: **23.04.1997**
(21) Application number: 89908662.3
(22) Date of filing: 17.07.1989
(51) Int. Cl.: H01L 39/24

(54) **DESIGN AND FABRICATION OF SYNTHETIC SUPERCONDUCTORS**
ENTWURF UND HERSTELLUNG VON SYNTHETISCHEN SUPRALEITERN
CONCEPTION ET FABRICATION DE SUPRACONDUCTEURS SYNTHETIQUES

(30) Priority: 22.07.1988 US 222806
(43) Date of publication of application: 16.08.1990
(73) Proprietor: ARTHUR D. LITTLE, INC., Cambridge, MA 02139 (US)
(72) Inventor: RONA, Mehmet, Belmont, MA 02178 (US)
(74) Representative: Warren, Anthony Robert
(86) International application number: US8903063
(87) International publication number: WO9001218

(56) References cited:
- Physica C, Vol. 152, No. 4, 1 June 1988, Elsevier Sciences Publising Division (Amsterdam, NL) J. UY et al.: "Electronic Structure and Properties of the High- Tc Superconductors: T12Ba2CaCu2O8 and T12Ba2Ca2Cu3O10" pages 273-282
- Physical Review B. Condensed Matter, Vol. 34, No. 6, September 1986 The American Physical Society (New York, US) M.G. KARKUT et al.: "Quasiperiodic Metallic Multilayers: Growth and Superconductivity", pages 4390-4393
- Physical Review Letters, Vol. 55, No. 17, 21 October 1985, The American Physical Society (New York, US), R. MERLIN et al.: "Quasiperidic GaAs-A1As heterostructures", pages 1768-1770

## Description

### FIELD AND BACKGROUND OF THE INVENTION

The present invention relates to a synthetic superconductor operating at temperatures substantially above those temperatures near absolute zero where conventional superconduction has been observed. These elevated superconduction temperatures are already seen in a selected group of chemical compounds in the vicinity of 100°K, for example. Such high temperature superconductors comprise a crystal structure containing a copper oxide formulation in which various elements, including thallium, calcium, yttrium and barium, to name a few, are incorporated. The particular collection of elements leading to compounds which exhibit good superconductivity properties are obtained through trial and error. Various theories have attempted to provide a description of superconductivity. They all attribute such superconductivity to layers of two dimensional copper and oxygen atoms within the crystal lattice. These layers are separated by low conductivity monodirectional filaments or one dimensional chains of copper oxide in the crystal structure.

The production of materials which are superconducting at elevated temperatures suffers from a number of production problems which limit the utility of such superconducting materials. These problems include not only the difficulty of identifying appropriate compositional mixes and production parameters which lead to superconductivity but also the difficulty in producing superconducting materials with mechanical strength, chemical stability and dimensional properties useful for high current applications. The difficulty in identifying new materials with desirable properties is attributable to a lack of an understanding of the superconducting mechanism in the new generation of elevated temperature superconducting materials, and has left these high temperature superconductors without present serious utility in actual industrial applications.

The present invention consists in a heterogeneous multilayer superconductor comprising a plurality of higher conducting layers formed of a metallic material or doped semiconductor material, having a first electrical conductance in a direction parallel to the layer and a first charge carrier density per unit area of the layer; at least one lower conducting layer formed of a metallic material or doped semiconductor material, having a second said electrical conductance lower than the first and a second said charge carrier density per unit area lower than said first charge carrier density; and a plurality of electrically insulating layers wherein each of said higher conducting layers is separated from a lower conducting layer by one of said electrically insulating layers, the higher and lower conducting layers being from one to several atoms in thickness and the electrically insulating layers having a thickness of several Ångströms whereby said higher and lower conducting layers cooperate to cause charge carriers in the first higher conducting layers to be electrostatically bound by a potential well induced by a charge distribution in the lower conducting layer, to provide superconduction in a direction parallel to said layers.

In the following description, an understanding of the conduction mechanism of superconduction at elevated superconduction temperatures is first presented. A description is then presented of synthetic superconductor structures and a fabrication which will lead to useful superconductivity at elevated superconduction temperatures.

The spacing function is provided by any insulating material including dielectrics, free space, etc. The layers, their spacing and conductivity levels are selected to produce electrostatic forces between the free charge carriers of the higher and lower conducting layers which cause the carriers in the lower conducting layers to be electrostatically paired or grouped in small clusters defined by potential wells resulting from the properties and geometry of the layered structure. The resulting construction provides for superconductivity through the interplay of the higher and lower conducting layers. The lower conducting layer is thus central to the exhibited superconductivity.

The superconductors according to the present invention are fabricated, in one embodiment, by depositing or plating layers of the higher and lower conducting strata one to several atoms in thickness, separated by an insulator, typically of very low dielectric constant, in order to permit the electrostatic forces required for charge pairing in the lower conducting layers to be strong.

Preferred embodiments of the present invention will now be described in detail with reference to the accompanying drawings in which:
FIGS. 1A, 1B and 1C are crystal structures illustrating prior art superconducting ceramic designs;
FIG. 2 is a structure diagram illustrating the fabrication of a superconductor according to the present invention;
FIG. 3 is a diagram illustrating the electrostatic interaction leading to superconduction according to the present invention;
FIG. 4 is a potential diagram illustrating the electrostatic attraction effects of Fig. 3;
FIG. 5 is a diagram illustrating one form of deposition equipment for producing layered superconducting material of the present invention; and
FIG. 6 is a processing diagram illustrating the steps in the fabrication of a superconductor according to the present invention.

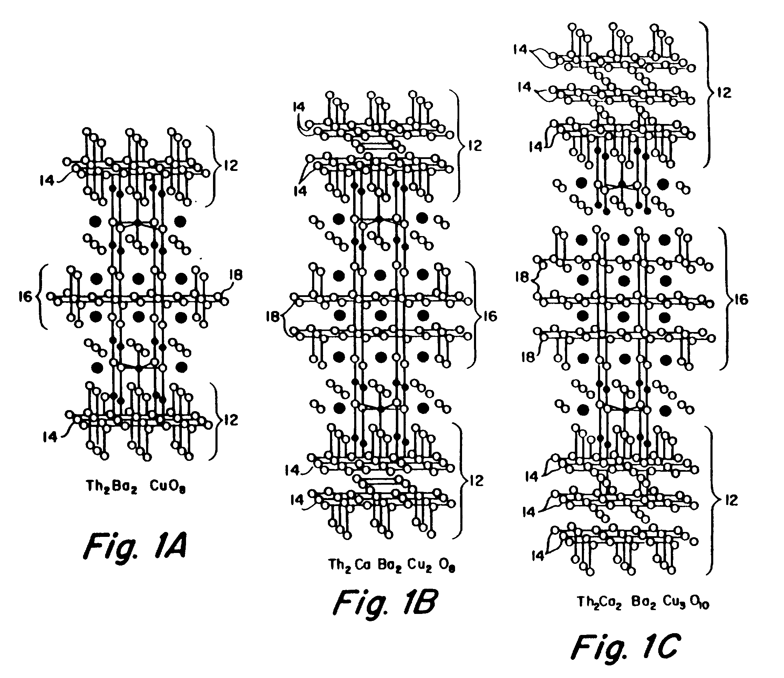

The arrangement of the present invention is distinct from conventional elevated temperature superconducting materials which comprise a crystal of, among other constituents, copper oxide as illustrated in Figs. 1A-1C. As shown in Figs. 1A-1C, crystal structures of the indicated formulation have been analyzed by X-ray diffraction to indicate a plurality of generally parallel planes 12 of copper oxide 14. These are spaced by one dimensional linear chains 16 of copper oxide 18. Additive atoms of thallium, barium, calcium, etc. are interspaced in the crystal to promote free carrier formation. The superconduction is envisioned as occurring the planes 12. Fabrication of the crystal structure of Figs. 1A-1C includes combining the requisite elements, such as selected combinations of thallium, yttrium, barium or calcium, with copper and their oxides, for example. The controls over fabrication of superconducting materials according to this recipe is not understood and obtaining superconducting results is strictly by trial and error. The crystal structure which results when the lattice is realized is a complex combination of various elements and copper oxide networks without any predictability of results based upon the crystal structure appearance.

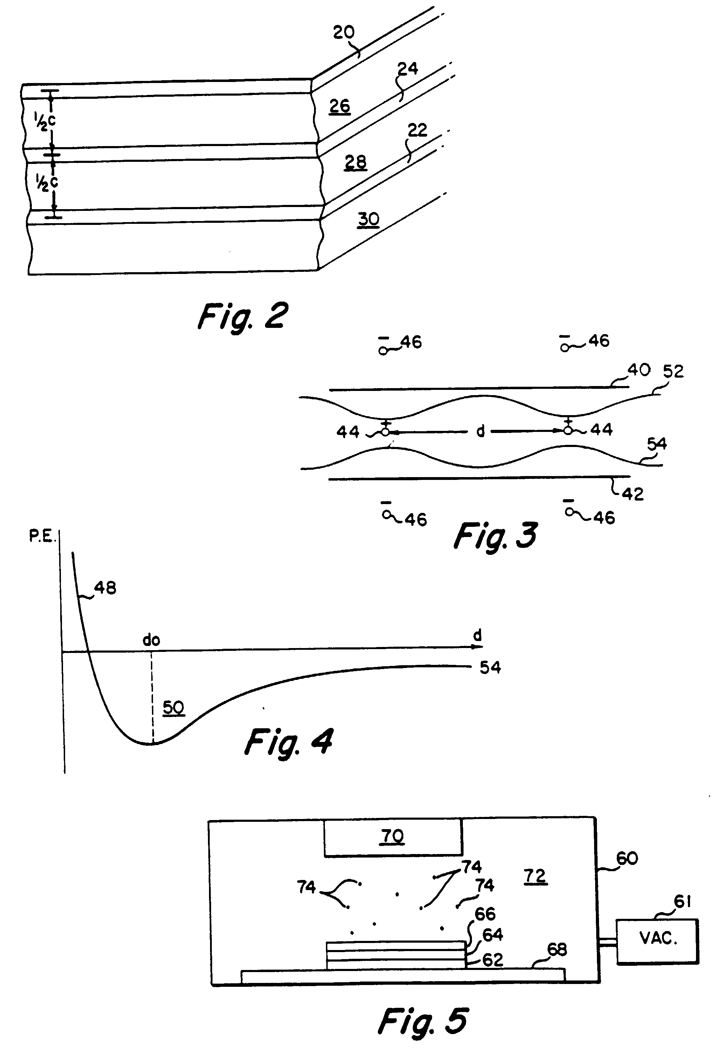

By contrast, superconductivity according to the present invention is accomplished by a controlled layering of higher and lower conducting strata separated by insulators as generally illustrated in Fig. 2. As shown there, a superconductor according to the present invention comprises a set of higher conducting layers 20 and 22 separated by a lower conducting layer 24 with each of the higher or lower conducting layers 20, 22 and 24 spaced by insulating layers 26 and 28 which may be a dielectric material or free space. The layered structure is typically assembled on a substrate 30 by plating or particle deposition and may be repeated a plurality of times upon top of the layer 20. Typically the layers 20 and 22 will be the same metal conductor while the layers 26 and 28 will be the same insulating or dielectric material. Various processes may be used to produce each layer. For example, particle deposition by sputtering, and other techniques can be used to produce a disordered amorphous or polycrystalline film layer. Single crystal expitaxial film layers can be grown by chemical vapor deposition (CVD or MOCVD) organo metallic CVD, or high vacuum molecular beam epitaxy (MBE). Assisted or reactive deposition, liquid melt deposition as well as plating may be used as appropriate.

The layer 24 in one embodiment is achieved by depositing the same material utilized to produce the layers 20 and 22 but at a sufficiently lower thickness in order to lower its overall conductivity according to the theoretical considerations presented below. Typically, the layer 24 may be of a thickness, for example, of three atoms while the layers 20 and 30 may be several times that in thickness. The materials for the layers 20 and 22, and optionally layer 24, are typically chosen to have good electrical conductivity properties and in particular are selected for as many free electrons per atom as can be conveniently obtained. Typical examples of such materials are metal like, gold, silver, berryllium and copper. The partial or lesser conducting layer 24, if of a different material than the metals used for the layers 20 and 22, may be of titanium, or aluminum as examples. None of these examples are intended to be limitations on the metal or its nature for the layers 20, 22 and 24. The theoretical considerations presented below will indicate the guidelines for the use of other materials.

The layers 20 and 24 as well as 22 and 24 are spaced by a thickness, "C", which is typically on the order of ten Angstroms, but is more generally governed by the theoretical considerations identified below. It is preferable that the dielectric constant of the layers 26 and 28 separating the layers 20, 24 and 22 be relatively low, typically as close to 1 as is reasonable. This is for practical considerations of dimensioning the layers and not seen as a limitation. Typical examples for the layers 26 and 28 include silicon dioxide, silicon nitride, various fluoride compounds, glasses, and a diamond-like carbon film layer.

While the description above has focused on exemplary layers 20-30 in substantially planar disposition, it is to be understood that the invention is not to be so limited, but includes curved layers as might result from forming the layers as cylinders on a rotating preform. Additionally, the layers could be produced as semiconductor layers with suitable doping.

In the case of semiconductor layering in a semiconductor such as gallium arsenide, it is convenient to make the lower conducting layer of a doped GaAs semiconductor and the higher conducting layer of a grown metal layer or degeneratively doped GaAs. The conductive layers would be separated by grown layers of insulator, Al_{X} Ga₁₋ₓ As. The higher conducting layer can have the number of charge carriers in a one cm square area of thickness t equal to or greater than 10¹³. This implies a thickness t, for this layer greater than 10¹³/n, where n is the density of charge carriers per cm³. For the lower conducting layer the number of charge carriers in a one cm square area of thickness t should be less than 10¹². The layer thickness T is then constrained to be less than 10¹²/n. If a one atom thick layer is considered, then n is limited to be less than 3 X 10¹⁹/cm³ for the lower conducting layer. For the higher conducting layer n could exceed 10²¹/cm³.

To understand the specific dimensioning and composition of the superconducting material of Fig. 2 a theoretical explanation illustrated by Figs. 3 and 4 provides useful guidelines. In Fig. 3, first and second conducting plates 40 and 42 are shown to represent respectively the conductors 20 and 22. Centered between the plates 40 and 42 are charge carriers 44 which may be either positive or negative charge carriers typically representing the free or partially free charge carriers in the lower conducting layer 24. In order to develop a field theory for the electrostatic field surrounding the carriers 44 as well as the potential field around them, resort is had to image analysis, in which case an array of additional alternately charged particles 46 are substituted for the plates 40 and 42. The resulting field and potential equation results from the superposition of the contributions from each carrier 44 and each particle 46. The resulting field can be summarized in a potential energy diagram illustrated in Fig. 4 as a function of the distance, "d", separating the charge carriers 44 from each other. Different sets of potential curves 48 can be generated for different values of "C". For a range of C's, typically in the 10 Angstrom range, a potential diagram as illustrated in Fig. 4 will result. The potential curve shows a potential well 50 indicating that the carriers 44, contrary to conventional thinking, will not be repulsed from each other but will rather be attracted to each other to a stable separation distance, represented by the bottom of the potential well 50, at the separation "dₒ".

Returning to the considerations of the higher conducting layer 40 and 42 in Fig. 3, each of the carriers 44 will cause free carriers in the layers 40 and 42 to move under the influence of the electrostatic effects produced by the carriers 44 creating charge distributions 52 and 54 respectively in each plate as illustrated. The charges in the plates 40 and 42 will cause an attractive effect between the carriers 44. Because of the conductivity of the plates 40 and 42 the charge bunching in plates 40 and 42 produced by one carrier 44 will have no net effect on that carrier 44 but the charge bunching produced by its neighboring carrier 44 will indeed be felt by the first carrier 44 in such manner as to draw the carriers 44 together forming pairs despite being of the same charge. For this to function effectively, it is advantageous to have the plates 40 and 42, or the layers 20 and 22, as conductive as possible. On the other hand the layer 24, containing the carriers 44, should have relatively fewer free or partially free charge carriers in order that their electric fields will not be shielded and cancelled, so that effective pairing or grouping in repeating clusters of carriers 44 will occur according to the electrostatics described above. If the charge carriers in the layer 24 are too prevalent, there will result a situation simply reflected by two parallel conductors.

Returning to theory, the dimension of the separation of the conducting layers, "C", is governed by the consideration that the binding energy between the charge carriers 44, considered as the difference between the bottom of the energy well 50 and the asymptotically approached limit of potential energy 54, reached at "d" equal to infinity, varies as a function of a factor representing the conductivity of the layers 20 and 22 over the product of the separation, "C/2" and the dielectric constant of the insulators 26 and 28. Interestingly, hindsight indicates that fitting this theoretical potential energy theory to the experimentally observed results for known materials of the type illustrated in Fig. 1 indicates a substantially perfect fit, confirming the accuracy of the theory in predicting superconductivity.

Given this theory, a more practical approach to achieving superconductivity is achieved by synthesizing materials constituted of layers of the sort illustrated in Fig. 2 or a more controlled approach in which strata of conducting and lesser conducting layers are achieved. Under these theoretical guidelines, the constraints on the dimensions are indeed limited only by the necessity to achieve a potential well effect as illustrated in Fig. 4 and a controlled number of charge carriers, holes or electrons, freely available in the layer 24, as well as a limited number of carriers paired or grouped in each potential well, typically a few electrons or holes as the case may be. The diameter of the grouped carrier ensemble is typically on the same size order, 10 to 15 Angstroms, as the separation, "C", of the conducting layers 20 and 22.

The important considerations are thus a relatively good level or density of free charge carriers in the conducting layers 20 and 22 and a more restricted availability in the layers 24. In addition, a separation of the layers as a function of the dielectric constant is also important. Consistent with the above observations the conducting layers 20 and 22 will typically have the number of carriers in a one cm² area be greater than 10¹³. For practical thicknesses, the volume density of carriers will be greater than 10²¹ per cm³. The layers should be of high purity as well. Similarly the lower conducting layers will have volume densities of carriers on the order of 10¹² particles per cm³ or less and a Debye length which is greater than the average interparticle spacing in order to permit the electrostatic fields to act through the lower conducting layers. As the dielectric constant of the insulators 26 and 28 increases, to maintain the same conditions, the separation must decrease. It is therefore practically advantageous to maintain the dielectric constant of the layers 26 and 28 as close to unity as possible. These figures are only quantitative guides and are not to be seen as limitations.

Apparatus for producing the layered structure of the embodiment represented in Fig. 2 can include any form of appropriate deposition, plating or microstructure forming apparatus. Such apparatus is illustrated in Fig. 5 in general in which layers 62, 64, 66 on a substrate 68 are deposited, grown or otherwise built up by any of the processes noted above or any other suitable processes within a vacuum chamber 60. An evacuating apparatus 61 maintains the interior 72 of the chamber 60 at a low enough pressure which prevents interference with the layer generation process. Particles 74 from a source 70, collect on the top surface of the layered structure.

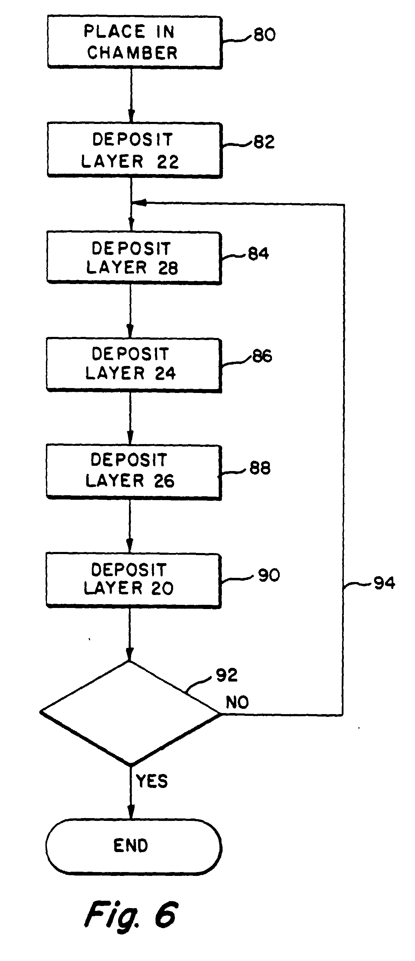

In typical implementation the fabrication process will proceed according to the steps of Fig. 6. Initially, in step 80 the substrate 66 is placed into the chamber 60 and an appropriate vacuum, achieved. With the appropriate vacuum, a subsequent step 82 deposits the first layer 22. Subsequent steps 84, 86, 88, and 90 deposit the layers 28, 24, 26, and 20 as illustrated above. Steps 84 through 90 may be repeated by exiting a decision step 92 on a branch 94 calling for repetition of the layers in a repeating sandwich structure. Alternatively, decision step 92 may limit or terminate the layering according to programmed control produced by a controller 96. The commencement of layer formation may begin at any layer so long as the correct sequence is followed.

In practical application, there will typically be provided within the chamber 60 plural particle sources 70 to accommodate the various materials to be produced in each of the processing steps 82-90. This avoids the necessity to break the vacuum in the processing chamber 60 between each deposited layer in order to install an additional sputtered particle source.

Additional instrumentation may be associated with the processing chamber 60, such as thickness detection instrumentation, in order to automatically terminate deposition as a function of deposited layer thickness.

## Claims

1. A heterogeneous multilayer superconductor comprising:
a plurality of higher conducting layers (20, 22) formed of a metallic material or doped semiconductor material, having a first electrical conductance in a direction parallel to the layer and a first charge carrier density per unit area of the layer;
at least one lower conducting layer (24) formed of a metallic material or doped semiconductor material, having a second said electrical conductance lower than the first and a second said charge carrier density per unit area lower than said first charge carrier density; and
a plurality of electrically insulating layers (26, 28)
wherein each of said higher conducting layers (20, 22) is separated from a lower conducting layer (24) by one of said electrically insulating layers (26, 28),
the higher and lower conducting layers being from one to several atoms in thickness and the electrically insulating layers having a thickness of several Ångströms whereby said higher and lower conducting layers cooperate to cause charge carriers in the first higher conducting layers to be electrostatically bound by a potential well induced by a charge distribution in the lower conducting layer, to provide superconduction in a direction parallel to said layers.

2. A superconductor according to claim 1 which includes a plurality of alternating higher conducting layers (20, 22) and lower conducting layers (24) each separated by one of said insulating layers (26, 28).

3. A superconductor according to claim 1 or claim 2 wherein the electrically insulating layers (26, 28) are of a thickness of the order of 1nm.

4. A superconductor according to any preceding claim wherein the electrically insulating layers are characterised by a dielectric constant that is substantially 1.

5. A superconductor according to any preceding claim wherein the material of said higher conducting layers (20, 22) is selected from a degenerately doped semiconductor, titanium, aluminium, beryllium, gold, silver, and copper.

6. A superconductor according to claim 5 wherein the semiconductor is gallium arsenide.

7. A superconductor according to any preceding claim wherein the material of the lower conducting layer (24) is selected from a non-degenerately doped semiconductor, titanium and aluminium.

8. A superconductor according to claim 7 wherein the semiconductor is gallium arsenide.

9. A superconductor according to any preceding claim wherein each electrically insulating layer (26, 28) comprises AlₓGa₁₋ₓAs (where 0 < x < 1), oxides, nitrides, fluorides, glasses or a carbon film with a diamond structure.

10. A superconductor according to any preceding claim wherein the higher conducting layer (20, 22) is characterised by a volume density of carriers greater than 10²¹ charge carriers per cm³.

11. A superconductor according to any preceding claim wherein each said higher conducting layer (20, 22) is of a thickness such that it has a charge carrier density of at least 10¹³ carriers per cm² of the layer.

12. A superconductor according to any preceding claim wherein the lower conducting layer (24) is characterised by a volume density of carriers less than 3 x 10¹⁹ carriers per cm³.

13. A superconductor according to any preceding claim wherein the or each said lower conducting layer (24) is of a thickness such that it has a charge carrier density of at least 10¹² carriers per cm².

14. A superconductor according to any preceding claim wherein the or each said lower conducting layer (24) is from one to three atoms thick.

15. A superconductor according to claim 14 wherein each said higher conducting layer (20, 22) has a thickness several times that of the lower conducting layer (24).

16. A superconductor according to any one of claims 1 to 14 wherein each of said higher and lower conducting layers (20, 22, 24) is of substantially the same thickness, the higher conducting layers (20, 22) being of a metal of higher conductivity than that of the material of the lower conducting layer (24).

17. A superconductor according to any preceding claim wherein the higher conducting layers (20, 22) have a Debye length greater than the average interparticle spacing.

18. A superconductor according to any preceding claim wherein said layers (20, 22, 24, 26, 28) have a curved shape.

19. A process for forming a superconductor according to any preceding claim which includes the steps of forming, in sequence, a higher conducting layer (22) at a thickness of one to several atoms, a layer (28) of an insulating material with a thickness of several Ångströms, a lower conducting layer (24) at a thickness from one to several atoms, another layer (26) of insulating material with a thickness of one to several Ångströms and another said higher layer (20) of a thickness of one to several atoms.

20. A process according to claim 19 wherein said higher and lower conducting layers (20, 22, 24) are formed by deposition, plating or layer growth with or without doping.

21. A process according to claim 19 or claim 20, wherein the formation of said higher and lower conducting layers (20, 22, 24) includes the step of sputtering.

22. A process according to any one of claims 19 to 21, wherein said insulating layers (26, 28) are formed by particle deposition.

23. A process according to any one of claims 19 to 21, wherein the insulating layers (26, 28) are formed by sputtering.

24. A process according to any one of claims 19 to 23, wherein said higher (20, 22) and lower (24) conducting layers are formed by applying layers of the same material for said higher and lower conducting layers, the higher conducting layers (20, 22) being applied at a greater thickness than the lower conducting layer (24).

25. A process according to any one of claims 19 to 24, wherein said layers are formed in a curved shape.

26. A process according to any one of claims 19 to 25, wherein said higher and lower conducting layers (20, 22, 24) are formed by forming doped semiconductor layers.

## Patentansprüche

1. Heterogener Mehrschicht-Supraleiter, umfassend:
eine Vielzahl höherleitender Schichten (20, 22), die aus einem metallischen Material oder einem dotierten Halbleitermaterial gebildet sind, das eine erste elektrische Leitfähigkeit in einer schichtparallelen Richtung und eine erste Ladungsträgerdichte pro Schichtflächeneinheit aufweist;
mindestens eine schwächerleitende Schicht (24), die aus einem metallischen Material oder einem gedopten Halbleitermaterial gebildet ist, das eine zweite elektrische Leitfähigkeit, die geringer als die erste ist, und eine zweite Ladungsträgerdichte pro Flächeneinheit, die geringer als die erste Ladungsträgerdichte ist, aufweist; und
eine Vielzahl elektrisch isolierender Schichten (26, 28), wobei jede der höherleitenden Schichten (20, 22) von einer schwächerleitenden Schicht (24) durch eine der elektrisch isolierenden Schichten (26, 28) getrennt ist,
die höher- und schwächerleitenden Schichten eine Dicke von einem bis mehreren Atomen haben und die elektrisch isolierenden Schichten eine Dicke von mehreren Angström aufweisen, wodurch die höher- und schwächerleitenden Schichten zusammenwirken, um die Ladungsträger in den ersten höherleitenden Schichten dazu zu bringen, durch eine Potentialsenke, die durch eine Ladungsverteilung in der schwächerleitenden Schicht induziert wird, elektrostatisch gebunden zu sein, um eine Supraleitung in einer Richtung parallel zu den Schichten zu schaffen.

2. Supraleiter nach Anspruch 1, der eine Vielzahl alternierender höherleitender Schichten (20, 22) und schwächerleitender Schichten (24) umfaßt, die jeweils durch eine der isolierenden Schichten (26, 28) getrennt sind.

3. Supraleiter nach Anspruch 1 oder Anspruch 2, wobei die elektrisch isolierenden Schichten (26, 28) eine Dicke im Bereich von 1 nm aufweisen.

4. Supraleiter nach jedem der vorangehenden Ansprüche, wobei die elektrisch isolierenden Schichten durch eine Dielektrizitätskonstante gekennzeichnet sind, die im wesentlichen gleich 1 ist.

5. Supraleiter nach jedem der vorangehenden Ansprüche, wobei das Material der höherleitenden Schichten (20, 22) aus einem entartet dotierten Halbleiter, Titan, Aluminium, Beryllium, Gold, Silber und Kupfer gewählt ist.

6. Supraleiter nach Anspruch 5, wobei der Halbleiter Galliumarsenid ist.

7. Supraleiter nach jedem der vorangehenden Ansprüche, wobei das Material der schwächerleitenden Schicht (24) aus einem nicht-entartet dotierten Halbleiter, Titan und Aluminium gewählt ist.

8. Supraleiter nach Anspruch 7, wobei der Halbleiter Galliumarsenid ist.

9. Supraleiter nach jedem der vorangehenden Ansprüche, wobei jede der elektrisch isolierenden Schichten (26, 28) AlₓGa₁₋ₓAs (mit 0 < x < 1), Oxide, Nitride, Fluoride, Gläser oder eine Kohlenstoffschicht mit einer Diamantstruktur umfaßt.

10. Supraleiter nach jedem der vorangehenden Ansprüche, wobei die höherleitende Schicht (20, 22) durch eine Trägervolumendichte gekennzeichnet ist, die größer als 10²¹ Ladungsträger pro cm³ ist.

11. Supraleiter nach jedem der vorangehenden Ansprüche, wobei jede der höherleitenden Schichten (20, 22) eine solche Dicke besitzt, daß sie pro cm² der Schicht eine Ladungsträgerdichte von mindestens 10¹³ Trägern aufweist.

12. Supraleiter nach jedem der vorangehenden Ansprüche, wobei die schwächerleitende Schicht (24) durch eine Trägervolumendichte gekennzeichnet ist, die kleiner als 3 x 10¹⁹ Ladungsträger pro cm³ ist.

13. Supraleiter nach jedem der vorangehenden Ansprüche, wobei die oder jede der schwächerleitenden Schichten (24) eine solche Dicke besitzt, daß sie eine Ladungsträgerdichte von mindestens 10¹² Trägern pro cm² aufweist.

14. Supraleiter nach jedem der vorangehenden Ansprüche, wobei die oder jede der schwächerleitenden Schichten (24) ein bis drei Atome dick ist.

15. Supraleiter nach Anspruch 14, wobei jede der höherleitenden Schichten (20, 22) eine Dicke besitzt, die um ein Mehrfaches größer ist, als diejenige der schwächerleitenden Schicht (24).

16. Supraleiter nach jedem der vorangehenden Ansprüche 1 bis 14, wobei jede der höher- und schwächerleitenden Schichten (20, 22, 24) im wesentlichen die gleiche Dicke besitzt und die höherleitenden Schichten (20, 22) aus einem Metall höherer Leitfähigkeit als derjenigen des Materials der schwächerleitenden Schicht (24) bestehen.

17. Supraleiter nach jedem der vorangehenden Ansprüche, wobei die höherleitenden Schichten (20, 22) eine Debye-Länge aufweisen, die größer als der durchschnittliche Teilchenzwischenabstand ist.

18. Supraleiter nach jedem der vorangehenden Ansprüche, wobei die Schichten (20, 22, 24, 26, 28) eine gebogene Form aufweisen.

19. Verfahren zur Bildung eines Supraleiters gemäß jedem der vorangehenden Ansprüche, welches die Schritte umfaßt: aufeinanderfolgende Bildung einer höherleitenden Schicht (22) mit einer Dicke von ein bis mehreren Atomen, einer Schicht (28) us einem isolierenden Material mit einer Dicke mehrerer Angström, einer schwächerleitenden Schicht (24) mit einer Dicke von ein bis mehreren Atomen, einer weiteren Schicht (26) aus einem isolierenden Material mit einer Dicke mehrerer Angström und einer weiteren höherleitenden Schicht (20) einer Dicke von ein bis mehreren Atomen.

20. Verfahren nach Anspruch 19, wobei die höher- und schwächerleitenden Schichten (20, 22, 24) durch Ablagerung, Plattierung oder Schichtaufspratzung mit oder ohne Dotierung gebildet werden.

21. Verfahren nach Anspruch 19 oder Anspruch 20, wobei die Bildung der höher- und schwächerleitenden Schichten (20, 22, 24) den Schritt des Sputterns umfaßt.

22. Verfahren nach jedem der vorangehenden Ansprüche 19 bis 21, wobei die isolierenden Schichten (26, 28) durch Teilchenablagerung gebildet werden.

23. Verfahren nach jedem der vorangehenden Ansprüche 19 bis 21, wobei die isolierenden Schichten (26, 28) durch Sputtern gebildet werden.

24. Verfahren nach jedem der vorangehenden Ansprüche 19 bis 23, wobei die höher- und schwächerleitenden Schichten (20, 22, 24) durch Auftragen von Schichten aus dem gleichen Material der höher- und schwächerleitenden Schichten gebildet werden, wobei die höherleitenden Schichten (20, 22) mit einer größeren Dicke als die schwächerleitenden Schicht (24) aufgetragen werden.

25. Verfahren nach jedem der vorangehenden Ansprüche 19 bis 24, wobei die Schichten in einer gebogenen Form gebildet werden.

26. Verfahren nach jedem der vorangehenden Ansprüche 19 bis 25, wobei die höher- und schwächerleitenden Schichten (20, 22, 24) durch Bildung dotierter Halbleiterschichten gebildet werden.

## Revendications

1. Supraconducteur multicouches hétérogène, comprenant :
une pluralité de couches conductrices supérieures (20, 22), formées d'un matériau métallique ou d'un matériau semi-conducteur dopé, ayant une première conductance électrique dans une direction parallèle à la couche et une première densité de porteurs de charges par unité d'aire de la couche ;
au moins une couche conductrice inférieure (24), formée d'un matériau métallique ou d'un matériau semi-conducteur dopé, ayant une deuxième conductance électrique inférieure à la première, et une deuxième densité de porteurs de charges par unité d'aire inférieure à ladite première densité des porteurs de charge ; et
une pluralité de couches isolantes électriques (26, 28),
dans lequel chacune desdites couches conductrices supérieures (20, 22) est séparée d'une couche conductrice inférieure (24) par au moins l'une desdites couches isolantes électriques (26, 28),
les couches conductrices supérieures et inférieures ayant une épaisseur comprise entre un et plusieurs atomes, et les couches isolantes électriques ayant une épaisseur de plusieurs Angstroems, où lesdites couches conductrices supérieures et inférieures coopèrent pour faire en sorte que les porteurs de charges se trouvant dans les premières couches conductrices supérieures se fixent par fixation électrostatique à un puits de potentiel induit par une distribution des charges dans la couche conductrice inférieure, de façon à assurer une supraconduction dans une direction parallèle auxdites couches.

2. Supraconducteur selon la revendication 1, qui comprend une pluralité de couches conductrices supérieures (20, 22) et de couches conductrices inférieures (24) alternées, chacune étant séparée par l'une desdites couches isolantes (26, 28).

3. Supraconducteur selon la revendication 1 ou 2, dans lequel les couches isolantes électriques (26, 28) ont une épaisseur de l'ordre de 1 nm.

4. Supraconducteur selon l'une quelconque des revendications précédentes, dans lequel les couches isolantes électriques sont caractérisées par une constante diélectrique essentiellement égale à 1.

5. Supraconducteur selon l'une quelconque des revendications précédentes, dans lequel le matériau desdites couches conductrices supérieures (20, 22) est choisi parmi les semi-conducteurs à dopage dégénéré, le titane, l'aluminium, le béryllium, l'or, l'argent et le cuivre.

6. Supraconducteur selon la revendication 5, dans lequel le semi-conducteur est l'arséniure de gallium.

7. Supraconducteur selon l'une quelconque des revendications précédentes, dans lequel le matériau de la couche conductrice inférieure (24) est choisi parmi les semi-conducteurs à dopage non dégénéré, le titane et l'aluminium.

8. Supraconducteur selon la revendication 7, dans lequel le semi-conducteur est l'arséniure de gallium.

9. Supraconducteur selon l'une quelconque des revendications précédentes, dans lequel chaque couche isolante électrique (26, 28) comprend de l'AlₓGa₁₋ₓAs (où 0 < x < 1), des oxydes, des nitrures, des fluorures, des verres, ou un film de carbone ayant la structure du diamant.

10. Supraconducteur selon l'une quelconque des revendications précédentes, dans lequel la couche conductrice supérieure (20, 22) est caractérisée par une densité volumique des porteurs supérieure à 10²¹ porteurs de charge par cm³.

11. Supraconducteur selon l'une quelconque des revendications précédentes, dans lequel chacune desdites couches conductrices supérieures (20, 22) a une épaisseur telle qu'elle ait une densité de porteurs de charge d'au moins 10¹³ porteurs par cm² de la couche.

12. Supraconducteur selon l'une quelconque des revendications précédentes, dans lequel la couche conductrice inférieure (24) est caractérisée par une densité volumique des porteurs inférieure à 3 x 10¹⁹ porteurs par cm³.

13. Supraconducteur selon l'une quelconque des revendications précédentes, dans lequel la couche conductrice inférieure ou chacune desdites couches conductrices inférieures (24) a une épaisseur telle qu'elle ait une densité de porteurs de charge d'au moins 10¹² porteurs par cm².

14. Supraconducteur selon l'une quelconque des revendications précédentes, dans lequel la couche conductrice inférieure ou chacune desdites couches conductrices inférieures (24) a une épaisseur de 1 à 3 atomes.

15. Supraconducteur selon la revendication 14, dans lequel chacune desdites couches conductrices supérieures (20, 22) a une épaisseur plusieurs fois supérieure à celle de la couche conductrice inférieure (24).

16. Supraconducteur selon l'une quelconque des revendications 1 à 14, dans lequel chacune desdites couches conductrices supérieures et inférieures (20, 22, 24) a essentiellement la même épaisseur, les couches conductrices supérieures (20, 22) étant en un métal dont la conductivité est supérieure à celle du matériau de la couche conductrice inférieure (24).

17. Supraconducteur selon l'une quelconque des revendications précédentes, dans lequel les couches conductrices supérieures (20, 22) ont une longueur de Debye supérieure à la distance moyenne entre particules.

18. Supraconducteur selon l'une quelconque des revendications précédentes, dans lequel lesdites couches (20, 22, 24, 26, 28) ont une forme incurvée.

19. Procédé pour former un supraconducteur selon l'une quelconque des revendications précédentes, qui comprend les étapes consistant à former successivement une couche conductrice supérieure (22) sur une épaisseur de un ou à plusieurs atomes, une couche (28) en un matériau isolant ayant une épaisseur de plusieurs Angstroems, une couche conductrice inférieure (24) sur une épaisseur de un à plusieurs atomes, une autre couche (26) en un matériau isolant ayant une épaisseur de un à plusieurs Angstroems, et une autre couche supérieure (20), ayant une épaisseur de un à plusieurs atomes.

20. Procédé selon la revendication 19, dans lequel lesdites couches conductrices supérieures et inférieure (20, 22, 24) sont formées par déposition, placage ou croissance de couche, avec ou sans dopage.

21. Procédé selon la revendication 19 ou 20, dans lequel la formation desdites couches conductrices supérieures et inférieure (20, 22, 24) comprend l'étape de pulvérisation cathodique.

22. Procédé selon l'une quelconque des revendications 19 à 21, dans lequel lesdites couches isolantes (26, 28) sont formées par déposition de particules.

23. Procédé selon l'une quelconque des revendications 19 à 21, dans lequel les couches isolantes (26, 28) sont formées par pulvérisation cathodique.

24. Procédé selon l'une quelconque des revendications 19 à 23, dans lequel lesdites couches conductrices supérieures (20, 22) et inférieure (24) sont formées par application de couches en le même matériau pour lesdites couches conductrices supérieures et inférieures, les couches conductrices supérieures (20, 22) étant appliquées sur une épaisseur plus grande que la couche conductrice inférieure (24).

25. Procédé selon l'une quelconque des revendications 19 à 24, dans lequel lesdites couches sont formées avec une forme incurvée.

26. Procédé selon l'une quelconque des revendications 19 à 25, dans lequel lesdites couches conductrices supérieures et inférieure (20, 22, 24) sont formées par formation de couches de semi-conducteurs dopés.
